# EUROPEAN PATENT SPECIFICATION

(11) **EP 0 569 087 B1**
(45) Date of publication and mention of the grant of the patent: **04.09.1996**
(21) Application number: 93201244.6
(22) Date of filing: 01.05.1993
(51) Int. Cl.: H05K 7/18

(54) **Continuous joints particularly for frames of electrical cabinets and the like**
Kontinuierliche Verbindungen, insbesondere für Rahmen in elektrische Schränke oder dergleichen
Joints continus, notamment pour cadres d'armoires électriques

(30) Priority: 04.05.1992 IT MI921055
(43) Date of publication of application: 10.11.1993
(73) Proprietor: SIFE INDUSTRIALE S.p.A., I-Milano (IT)
(72) Inventor: Balzanelli, Vincenzo, Milano (IT)
(74) Representative: Raimondi, Alfredo, Dott. Ing. Prof.

(56) References cited:
- EP-A- 0 399 595
- DE-A- 2 353 574
- FR-A- 2 292 357

## Description

The object of this invention is an improved joint for the assembly of walls of containers, particularly for electrical, electronic or like equipment, in the form of a cabinet for floor-, wall- or embedded-mounting.

As is known, electrical panels for the control and/or distribution of electric power and numerous devices which need to be protected or assembled in a confined space are normally housed in metal containers, for example in the form of a cabinet with a hinged door, having one or more internal compartments and usually open at the top and bottom to allow the entry of cables, pipes and the like emerging from the wall or floor on which the container is mounted and secured.

Many types of containers are currently used for such purposes. There are in fact known containers of fixed structure, pre-assembled in the manufacturing plant and therefore of invariable capacity, and containers consisting of an assemblage of various components (flanks, top and bottom ends, removable and transferable shelves) which are assembled in some cases in the manufacturing plant and in other cases at the time of installation and commissioning of the container.

All of them indiscriminately display in practice many disadvantages of a practical and economic nature, as well as limited scope for varying their capacity in keeping with the uses for which they are intended.

Thus, the known containers for electrical panels, obtainable at the time of installation by assembling prefabricated components and using fasteners such as pins and screws or the like, involve long fitting times and low rigidity of the box-shaped body, especially after installing therein the electrical equipment, which in some cases is heavy and bulky.

Likewise, containers obtainable by the assembly of prefabricated components with embedded joints capable of being inserted at the end of the flanks and in the top and bottom ends necessitate auxiliary components capable of being attached in a removable manner to the flanks and at varying heights, to allow the formation of supporting members for the electrical equipment in the positions made necessary by the overall dimensions of such equipment. The embedded end-couplings used, in certain cases, to assemble various types of containers and made with two flanges or with three flanges located at 90° in relation to one another cannot be readily inserted into the recesses provided in the matching ends of the flanks, since, being formed of single-plate sections, their rigidity hampers insertion, and therefore they require accurate precision-machining of the surfaces of the flanges and of the recesses in the flanks, as well as fitting operations to achieve the desired orthogonality for the walls.

Examples of such known art are described in EP-A-O 399 595 in the name of the same applicant.

From EP-A-0399 595 there is known a sectional container for electrical equipment, the container comprising a plurality of profile elements constituting the side plates and the end plates and capable of being coupled together in a relative angular or linear position by means of fixed joints. The joints in the case of the side plate top coupling will have an angular configuration composed of two flanges connected at a right angle by means of a square bar having a side dimension greater than the thickness of the flanges ; in this manner, when the coupling is effected, the two flanges are forced onto the ends of the side and top elements respectively, until their edges come into bearing against the bar, thus forming an angle coupling.

There is therefore posed the technical problem of providing a connecting device for walls of containers housing electrical equipment and the like consisting of structural components which are interchangeable and capable of being linked to one another, which connecting devices should be such as to reduce the number of points of attachment to the flanks and ends, to ensure high rigidity of the assembled box-shaped body, to facilitate self-alignment of the said walls at the time of assembly and also to provide the coupling with clamping and handling facilities to allow transfer and movement of the said container regardless of its weight and overall dimensions.

Such technical problems are solved according to this invention by an assembly as defined in claim 1.

Further features and advantages of the invention may be obtained from the following description, given with reference to the attached set of drawings, which show:
- In figure 1 :: a container-cabinet of two-compartment design, made according to the invention, illustrated in exploded view;
- In figure 2 :: in an axonometric and exploded view, the relative position assumed by the constituent components of the container at the time of assembling the joint;
- In figure 3 :: a cross-section of a continuous embedded joint of three-way type;
- In figure 3a :: a sectional detail of the joint in figure 3;
- In figure 4 :: a wedge-shaped component constituting a non-slip body of the clamping blocks inserted between the rectilinear flanges of the joints, shown in cross-section;
- In figure 5 :: a detail of the handling facilities attached to a continuous joint, clamped by embedding in the crosspieces of the flanks and in those located at 90 from the top end, shown in axial section.

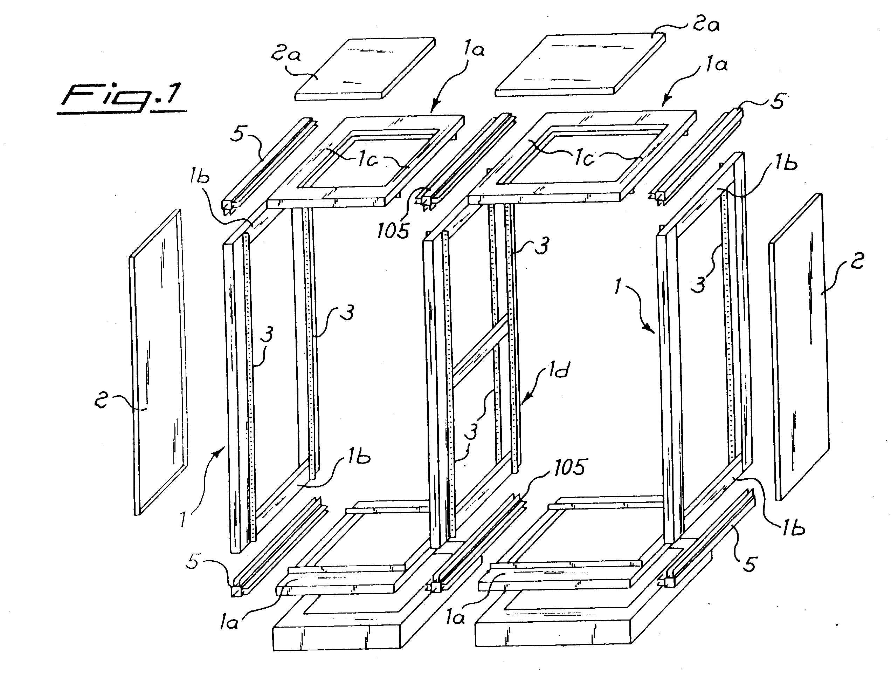

With reference to the above-mentioned figures, the container-cabinet for electrical equipment according to the invention is comprised of a multiplicity of rectangular box-shaped frames 1 of metal section, enclosed by continuous walls 2 and designed to form the flanks of the container, and of a multiplicity of like frames 1a and relevant enclosing panels 2a capable of constituting the top and bottom ends of the said container body. In figure 1 is illustrated, by way of an example, a container having two adjacent compartments. At either side or box-shaped upright of frame 1 is provided a longitudinal flange 3 extending over the full height, having equispaced holes or openings 3a (figs. 1 and 5). Between flanges 3 projecting from the matching frames are positioned at varying heights crosspieces and shelves of known type for accommodating electrical equipment and instrumentation. Furthermore, matching horizontal crosspieces 1b of frame 1 and crosspieces 1c of the ends to be joined together at the angle have their outer sides opened in such a way as to create quadrangular seats 4 extending over the entire length of such crosspieces 1b and throughout the thickness of the matching uprights. Such seats 4 provide means for the embedded attachment of continuous angular joints, generically marked 5 and 105, which will be more fully described hereinafter.

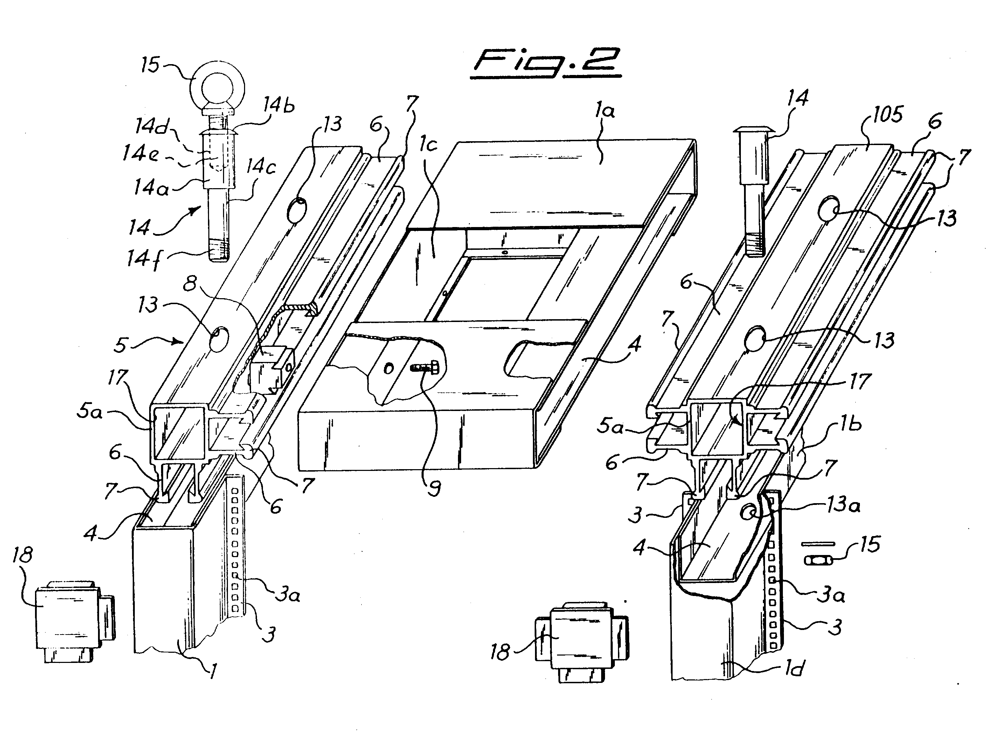

Such embedded joints 5 and 105 are comprised of quadrangular box-shaped sections 5a, of cross-section equal to that of the uprights and of the crosspieces of frames 1 and 1a (figs. 2-3) and of length equal to that of crosspieces 1b and 1c. Continuous joints 5 have, on two faces adjoining the box-shaped body, a pair of flanges 6 (figs. 2 and 5) parallel to one another, running along the entire length of the wall so as to form a substantially "C" section. The free ends of such flanges are lengthened or thickened to form two continuous projections 7 with wedge-shaped recess 7a, turned toward the wall which supports the matching pair of flanges. Each pair of parallel flanges 6 is located in a recessed position relative to the outer edge of box-shaped body 5a in order to enable it to be inserted into longitudinal cavity 4 of the crosspieces of the flanks and of the ends so as to place body 5a in a recessed manner on the said crosspieces and with the faces of its outer walls aligned coplanarly both with the vertical faces of the crosspieces and uprights and with the horizontal faces of the ends, as will be clear from the arrangement shown in fig. 5.

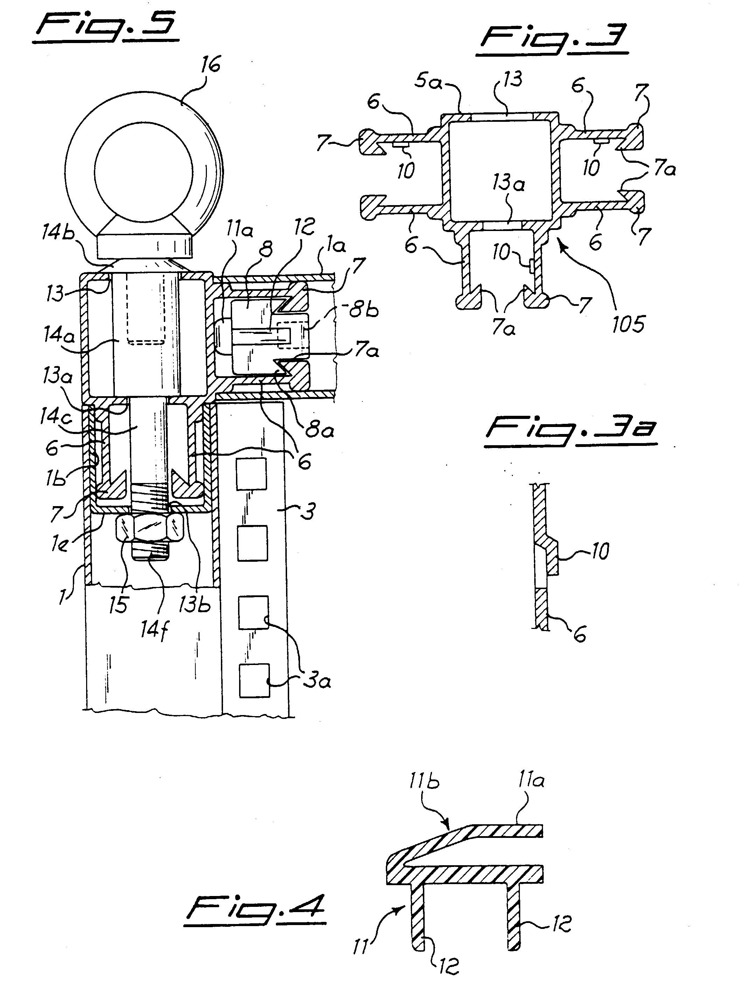

Joints 105 (figs. 2 and 3) have the same structure as joints 5 but with a further pair of flanges 6 located opposite one of the pairs of preexisting flanges to form a substantially "T" section. These joints make it possible, as illustrated in figures 1 and 2, to extend the container in a horizontal direction by inserting the opposite but parallel pairs of flanges 6 in two consecutive ends 1a (fig. 1) and the pair of flanges 6 at right angles to the previous ones in a frame 1d (fig.1). By this means the container is increased to double the volume of the previous one and frame 1d performs the function of a dividing wall between two compartments. Such frame 1d is open, i.e. devoid of wall 2, in order to allow the passage of cables or the like between the two compartments linking the equipment located separately in the two adjoining compartments.

Joints 5 in the case of a single container and joints 105 in the case of a container being a multiple of the former are obviously intended to link in the same manner the bottom ends of the relevant frames 1 and/or dividers 1d.

Stable clamping of joints 5, 105 within seats 4 provided in crosspieces 1b of the flanks and in crosspieces 1c of ends 2 is achieved by means of shaped blocks 8 (figs. 2 and 5) inserted slidingly between flanges 6 of each joint; each block 8 has on the faces in contact with matching flanges 6 a wedge-shaped angular chamfer 8a (fig. 5) matching the shape of ribs 7a located at ends 7 of such flanges 6. Engagement in the direction perpendicular to box-shaped body 5a of the joints, between blocks 8 and flanges 6, therefore makes it possible to secure each pair of flanges 6 to the crosspiece of the flanks and of the ends by means of a screw 9 (fig. 2) passing through such crosspieces and secured in a female thread 8b provided in such blocks 8.

To prevent movement of blocks 8 parallel to retaining flanges 6, there are provided on the inner face of at least one of each pair of flanges 6, at a preset distance, projections 10 capable of providing means of restraint for the said blocks. Such projections 10 may be obtained by bevelling or partial cutting of a part of the flange, bent inward as illustrated in figure 3a. Furthermore, to ensure positioning stability and in particular to avoid slipping of blocks 8, provision is made for a friction component 11 (fig. 4) in the form of a stopper or the like made of flexibly adaptable material such as rubber, nylon or the like, having a cap head 11a with a lateral inclined flat part 11b and two flanges 12, perpendicular to the cap and parallel to one another, spaced in such a way as to accommodate therein the prismatic body of block 8 (fig. 5). Such inclined flat part 11b makes it possible to achieve easy sliding of friction component 11 between matching flanges 6 during the insertion stroke, and conversely to counter the yielding of head 11a, forced between the wall of body 5a and block 8, thereby maintaining the friction created by the force exerted between the two matching walls and avoiding slipping of the block.

Again according to the invention, the particular structure of continuous longitudinally-embedded joints 5 and 105 described above and the use of flanks in the form of rigid frames make it possible to apply means for lifting the assembled container (even if already carrying the internal equipment) of the type consisting of a threaded pin with a looped head.

As shown in axial section in figure 5, continuous joints 5, 105 which connect upper crosspieces 1b of flanks 1, 1d to crosspieces 1c of top ends 1a are provided in the vicinity of their opposite ends with a hole 13 and, respectively, 13a (fig. 2) made in the two upper and lower horizontal walls of box-shaped body 5a of joint 5, 105, a corresponding hole 13b of smaller diameter than that of hole 13a and coaxial thereto being drilled in lower wall 1e of crosspieces 1b of the flank frames. Within such holes is inserted vertically a pin 14 the upper part of which comprises a head 14a, upwardly delimited by a collar 14b, having a diameter greater than that of shank 14c and a coaxial hollow seat 14d provided with female thread 14e. Such shank is furthermore provided with a thread 14f at its end. When the pin is inserted in coaxially-located holes 13, 13a, 13b, shank 14c passes through such holes, whilst head 14a is recessed with its lower part on the lower wall of box-shaped body 5a and with collar 14b on the upper wall of such body 5a. Threaded end 14f of shank 14c, which emerges from lower wall 1e of crosspiece 1b, is secured with locknut 15. In hollow seat 14d (fig. 2) within head 14a there may be screwed handling component 16 of the type comprising a ring with a threaded shank which, once screwed onto the pin, makes it possible to attach suitable means for handling and lifting the container without danger of the continuous joint slipping since the torque of locknut 15 is exerted against lower face 1e of crosspiece 1b which in turn is integral with the uprights of the flanks.

To make it then possible to hold still the looped head during tightening of locknut 15, the pin may be provided with a ribbed part in engagement with a seat located on the edge of a hole 13 of joint body 5b, which is self-evident and therefore not illustrated in the figure. Lastly, end openings 17 of joints 5, 105 are closed by covers or plates 18 (figure 2) capable of being applied frontally, embedded or by other means, to the peripheral edge of such openings in order to impart an attractive finish to the cabinet and to avoid the accumulation of dust. Many structural variants may furthermore be introduced, including for example joints with four pairs of symmetrical flanges to provide both horizontal and vertical extensions, without departing from the scope of protection of the invention as described in the following claims.

## Claims

1. Assembly of a coupling joint with rigid quadrangular frames (1) for constituting the walls and the top and bottom ends (1a) of containers with assemblable components, particularly for electrical equipment the joint (105) being continuous over the full depth of frame (1) and consisting of a quadrangular box-shaped section (5a) provided at least on two adjoining faces, located at right angles to one another, with a pair of rectilinear and parallel flanges (6) perpendicular to the said faces and of length equal to that of relevant box-shaped section (5a), the flanges providing means of embedded engagement between corresponding seats (4) provided longitudinally on crosspieces (1c, 1d) of the frames forming the flanks and the ends, stable assembly between joints (5, 105), flanks (1) and ends (1a) being obtained by means of screws (9) passing through such crosspieces (1b, 1c) and secured with corresponding female threads (8b) in shaped blocks (8) interposed between each pair of rectilinear flanges (6) of the joint (5, 105) and in stable engagement therewith, there being furthermore provided means (14, 16) attached to such joints (5, 105) for handling and lifting the containers.

2. Assembly according to claim 1, characterized in that such parallel flanges (6) have at their free ends a continuous rib (7) substantially in the shape of a wedge (7a) turned toward the box-shaped body (5a) of the joint, such ribs (7) in the shape of a wedge (7a) providing means of guidance for the insertion of the clamping blocks (8) between flanges (6) by coupling the said ribs with matching recesses (8a) provided in the opposite walls of such blocks (8).

3. Assembly according to claim 1, characterized in that it comprises a pair of flanges (6) at three adjoining faces of middle box-shaped body (5a), substantially of "T" section, capable of allowing attachment either according to two opposite horizontal directions or according to a vertical direction.

4. Assembly according to one or more of the previous claims, characterized in that on the internal walls of at least one of such pairs of flanges (6) are provided, at preset distances, projections (10) for retaining such blocks (8) in a preset position.

5. Assembly according to the previous claims, characterized in that between each block (8) and wall of boxed-shaped body (5a) of joints (5, 105) is interposed a stopper (11) made of flexibly adaptable material such as rubber plastic, provided with a flat inclined part (116) designed to facilitate sliding of the stopper in two directions and generation of friction by compulsion, thereby making it easier to insert block (8) and secure it in position.

6. Assembly according to the previous claims, characterized in that it has through-holes (13, 13a) coaxial with matching holes (13b) provided in walls (1e) of crosspieces (1b) of flanks (1) and capable of allowing the insertion of such means for clamping and handling the container, preferably consisting of pins (14) with a head having a collar (14b) and a shank with end thread (14f) capable of being secured to such crosspieces (1b) by means of a nut (15), such pins (14) being furthermore provided with a female thread (14d) inside head (14a) for attachment to looped-end components (16) for lifting and moving the assembled container.

7. Assembly according to the previous claims, characterized in that end openings (17) of such box-shaped bodies (5a) are closed by plates (18) applied to the edge of such open end (17) for embedding by snap action, or similar removable attachment, at the edge of such open ends (16).

## Patentansprüche

1. Aufbau einer Kupplungsverbindung mit festen rechtwinkligen Rahmen (1) zur Bildung der Wände und der oberen und unteren Enden (1a) von Behältern mit aneinanderfügbaren Bauteilen, insbesondere für elektrische Einrichtungen, wobei die Verbindungen (5, 105) ununterbrochen über die ganze Tiefe des Rahmens (1) sind und aus einem rechtwinkligen kastenförmigen Abschnitt (5a) bestehen, der auf mindestens zwei aneinandergrenzenden Flächen, die in rechten Winkeln zueinander angeordnet sind, mit einem Paar geradliniger und paralleler Flansche (6) versehen ist, die senkrecht zu der Fläche sind und eine Länge gleich der des relevanten kastenförmigen Abschnittes (5a) haben, wobei die Flansche Mittel zum eingebetteten Eingriff zwischen entsprechenden Sitzen (4) vorsehen, die der Länge nach auf Querträgern (1c, 1d) des Rahmens vorgesehen sind und die Seiten und die Enden bilden, ein stabiler Zusammenbau zwischen den Verbindungen (5, 105), den Seiten (1) und den Enden (1a) mittels Schrauben (9) erzielt wird, die durch die Querträger (1b, 1c) hindurchgehen und mit entsprechendem Innengewinde (8b) in geformten Blocks (8) befestigt sind, die zwischen jedem geradlinigem Flanschpaar (6) der Verbindung (5, 105) angeordnet sind und in dauerhaftem Eingriff damit sind, wobei weiterhin Mittel (14, 16) zur Handhabung und zur Anhebung des Behälters vorgesehen sind, die an diese Verbindungen (5, 105) angeschlossen sind.

2. Aufbau nach Anspruch 1, dadurch gekennzeichnet, daß die parallelen Flansche (6) an ihren freien Ende eine ununterbrochene Rippe (7) haben, die im wesentlichen die Form eines Keils (7a) haben, der zu dem kastenförmigen Körper (5a) der Verbindung gerichtet ist, wobei die Rippen (7) in der Form eines Keils (7a) Führungsmittel für das Einführen des Klemmblockes (8) zwischen den Flanschen (6) bereitstellen, durch Zusammenfügen der Rippen mit tastenden Ausnehmungen (8a), die in gegenüberliegenden Wänden der Blöcke (8) vorgesehen sind.

3. Aufbau nach Anspruch 1, dadurch gekennzeichnet, daß er ein Flanschpaar (6) auf drei aneinandergrenzenden Flächen des mittleren kastenförmigen Körpers (5a) aufweist, im wesentlichen als "T"-Profil, die Anschlüsse entweder in zwei gegenüberliegende horizontale Richtungen oder in eine vertikale Richtung erlaubt.

4. Autbau nach einem der vorangehenden Ansprüche, dadurch gekennzeichnet, daß auf den inneren Wänden von mindestens einem der Flanschpaare (6) in vorgewählten Abständen Vorsprünge (10) zum Zurückhalten der Blöcke (8) in einer vorbestimmten Stellung vorgesehen sind.

5. Aufbau nach einem der vorangehenden Ansprüche, dadurch gekennzeichnet, daß zwischen jedem Block (8) und Wand des kastenförmigen Körpers (5a) der Verbindungen (5, 105) ein Stopper (11) eingeschoben ist, der aus einem flexiblen anpassbaren Material wie Gummi oder Plastik gemacht ist, und mit einem flachen schrägen Abschnitt (116) versehen ist, gestaltet um ein Gleiten des Stoppers in zwei Richtungen zu ermöglichen und bei Zwang Reibung zu erzeugen, wodurch es leichter gemacht wird, den Block (8) einzufügen und in seiner Stellung zu sichern.

6. Aufbau nach einem der vorhergehenden Ansprüche, dadurch gekennzeichnet, daß er Durchgangslöcher (13, 13a) hat, koaxial mit passenden Löchern (13b), die in Wänden (1e) von Querträgern (1b) der Seiten (1) vorgesehen sind und das Einfügen von Mitteln zum Klemmen und Handhaben des Behälters gestatten, die vorzugsweise aus Stiften (14) mit einem Kopf bestehen, der einen Kragen (14b) und einen Schaft mit einem Gewindeende (14f) hat, die mittels einer Mutter (15) an den Querträgern (1b) betestigt werden können, die Stifte (14) sind weiterhin mit einem Innengewinde (14d) innerhalb des Kopfes (14a) zum Anschluß von Ösenenden-Bauteilen (16) zum Anheben und Bewegen des zusammengebauten Behälters versehen.

7. Aufbau nach einem der vorhergehenden Ansprüche, dadurch gekennzeichnet, daß die Endöffnungen (17) der kastenförmigen Körper (5a) durch Platten (18) an der Umrandung dieser offenen Enden (16) geschlossen sind, die an die Umrandung dieser offenen Enden (17) zum Einfügen durch Einschnappen oder eine ähnliche lösbare Befestigung angelegt werden.

## Revendications

1. Assemblage d'une liaison de montage avec des cadres rigides quadrangulaires (1), pour constituer les parois et les extrémités supérieure et inférieure (1a) d'armoires avec des éléments pouvant être montés, en particulier pour un équipement électrique, la liaison (5, 105) étant continue sur toute la profondeur du cadre (1), et étant constituée d'une section en forme de boîte quadrangulaire (5a) disposée au moins sur deux faces attenantes, situées à angles droits entre elles, avec une paire de brides rectilignes et parallèles (6) perpendiculaires auxdites faces, et de longueur égale à celle de la section en forme de boîte concernée (5a), les brides constituant des moyens d'engagement incorporé entre des sièges correspondants (4) disposés longitudinalement sur des éléments transversaux (1c, 1d) des cadres constituant les flancs et les extrémités, un assemblage stable entre les liaisons (5, 105), les flancs (1) et les extrémités (la) étant obtenu au moyen de vis (9) traversant ces éléments transversaux (1b, 1c), et étant vissés dans des taraudages femelles correspondants (8b) dans des blocs profilés (8) intercalés entre chaque paire de brides rectilignes (6) de la liaison (5, 105), et en engagement stable avec celles-ci, des moyens (14, 16) étant en outre installés, fixés à ces liaisons (5, 105), pour manipuler et soulever les armoires.

2. Assemblage selon la revendication 1, caractérisé en ce que ces brides parallèles (6) ont à leurs extrémités libres une nervure continue (7), sensiblement sous la forme d'un coin (7a), tournée vers le corps en forme de boîte (5a) de la liaison, ces nervures (7) sous la forme d'un coin (7a) constituant des moyens de guidage pour l'insertion des blocs de serrage (8) entre les brides (6), par engagement desdites nervures dans des cavités correspondantes (8a) disposées dans les parois opposées de ces blocs (8).

3. Assemblage selon la revendication 1, caractérisé en ce qu'il comprend une paire de brides (6) sur trois faces attenantes du corps en forme de boîte médian (5a), de section sensiblement en "T", pouvant permettre la fixation, soit selon deux directions horizontales opposées, soit selon une direction verticale.

4. Assemblage selon une ou plusieurs des revendications précédentes, caractérisé en ce que, sur les parois internes d'au moins l'une de ces paires de brides (6), sont prévues, à des distances réglées à l'avance, des projections (10) pour retenir ces blocs (8) dans une position réglée à l'avance.

5. Assemblage selon les revendications précédentes, caractérisé en ce que, entre chaque bloc (8) et la paroi du corps en forme de boîte (5a) des liaisons (5, 105), est intercalée une butée (11) faite de matière adaptable de façon souple, telle qu'un caoutchouc ou une matière plastique, pourvue d'une partie inclinée plate (116) conçue pour faciliter le coulissement de la butée dans deux directions, et la génération de frottement par contrainte, facilitant ainsi l'insertion du bloc (8) et le fixant en position.

6. Assemblage selon les revendications précédentes, caractérisé en ce qu'il comprend des trous traversants (13, 13a), coaxiaux avec les trous correspondants (13b) disposés dans les parois (1e) des éléments transversaux (1b) des flancs (1), et pouvant permettre l'insertion de moyens pour serrer et manipuler l'armoire, constitués de préférence de tiges (14), avec une tête comportant un anneau (14b), et une queue avec un filet d'extrémité (14f), pouvant être fixés à ces éléments transversaux (1b), au moyen d'un écrou (15), ces tiges (14) étant pourvues, de plus, d'un taraudage femelle (14d) à l'intérieur de la tête (14a), pour fixation à des composants d'extrémité en anneau (16), pour soulever et déplacer l'armoire montée.

7. Assemblage selon les revendications précédentes, caractérisé en ce que les ouvertures d'extrémité (17) de ces corps en forme de boîte (5a) sont fermées par des plaques (18) fixées au bord de cette extrémité ouverte (17) destinées à être encastrées par encliquetage, ou fixation démontable similaire, au bord de ces extrémités ouvertes (16).
